(19) **Europäisches Patentamt**

**European Patent Office**

**Office européen des brevets**

(11) **EP 1 354 925 B1**

(12) **EUROPEAN PATENT SPECIFICATION**

(45) Date of publication and mention
of the grant of the patent:
**26.04.2006 Bulletin 2006/17**

(51) Int Cl.:
*C09J 7/02* (2006.01)

(21) Application number: **03002644.7**

(22) Date of filing: **10.02.2003**

(54) **Heat-peelable pressure-sensitive adhesive sheet for electronic part, method of processing electronic part, and electronic part**

Durch Wärme abziehbare druckempfindliche Klebefolie, Verarbeitungsmethode für ein elektronisches Bauteil und ein elektronisches Bauteil

Feuille adhésive sensible à la pression pelable par chauffage, méthodes du traitement d' un composant électronique et d'un composant électronique

(84) Designated Contracting States:
**DE FR GB NL**

(30) Priority: **16.04.2002 JP 2002113604**

(43) Date of publication of application:
**22.10.2003 Bulletin 2003/43**

(73) Proprietor: **NITTO DENKO CORPORATION**
**Osaka (JP)**

(72) Inventors:
• **Kiuchi, Kazuyuki**
**Ibaraki-shi,**
**Osaka (JP)**
• **Kawanishi, Michirou**
**Ibaraki-shi,**
**Osaka (JP)**

(74) Representative: **Grünecker, Kinkeldey,**
**Stockmair & Schwanhäusser**
**Anwaltssozietät**
**Maximilianstrasse 58**
**80538 München (DE)**

(56) References cited:
**EP-A- 0 612 823      EP-A- 1 033 393**
**EP-A- 1 154 002      EP-A- 1 255 252**
**WO-A-02/33017**

• PATENT ABSTRACTS OF JAPAN vol. 1995, no.
10, 30 November 1995 (1995-11-30) -& JP 07
183195 A (NITTO DENKO CORP), 21 July 1995
(1995-07-21)
• PATENT ABSTRACTS OF JAPAN vol. 012, no. 467
(C-550), 7 December 1988 (1988-12-07) -& JP 63
186791 A (NITTO ELECTRIC IND CO LTD), 2
August 1988 (1988-08-02)

Remarks:
The file contains technical information submitted after
the application was filed and not included in this
specification

**Description**

**FIELD OF THE INVENTION**

The present invention relates to a heat-peelable pressure-sensitive adhesive sheet for electronic parts which after a heat treatment can be easily peeled from the electronic parts while causing little contamination. The invention further relates to a method of processing an electronic part using the heat-peelable pressure-sensitive adhesive sheet for electronic parts and to an electronic part produced by the processing method.

**DESCRIPTION OF THE RELATED ART**

Heat-peelable pressure-sensitive adhesive sheets comprising a substrate and formed thereon a pressure-sensitive adhesive layer containing a foaming agent or expanding agent, e.g., heat-expandable microspheres, have been known (see, for example, Japanese Patent Publications Nos. 50-13878 and 51-24534 and Japanese Patent Laid-Open Nos. 56-61468, 56-61469, and 60-252681). These heat-peelable pressure-sensitive adhesive sheets combine adhesiveness and peelability after use. This kind of pressure-sensitive adhesive sheet is characterized in that the adhesive force thereof is lowered by thermally foaming or expanding the foaming or expanding agent and, as a result, the adhesive sheet can be easily peeled from the adherend, e.g., silicon wafer. Due to such characteristics; these pressure-sensitive adhesive sheets are used, for example, for temporary fixation in the production of electronic parts.

However, use of such a heat-peelable pressure-sensitive adhesive sheet according to the related art for the dicing or back-side grinding of a semiconductor wafer (e.g., silicon wafer) poses the following problem. When the pressure-sensitive adhesive sheet applied is heat-treated and peeled off, the surface of the semiconductor wafer has many residual contaminants (in particular, organic contaminants) which are too fine to be visually recognized. This contamination problem has become serious because there are cases where the electronic parts thus produced are unsuitable for practical use.

Japanese Patent Laid-Open No. 6-306337 discloses a structure comprising a substrate, a rubbery organic elastic layer, and a heat-expandable layer. However, no technique for reducing the organic contamination or the like caused by an adhesive layer is described therein. The problem of organic contamination still remains unsolved.

This problem of organic contamination is thought to be attributable to a remarkable increase in the amount of contaminants due to the heat treatment, as apparent from a comparison between the contamination before heating and that after heating. There is a case where when contaminant particles on a 4-inch silicon wafer were conducted with a laser surface examination apparatus, the number of particles increased from less than 1,000 for sheet peeling without heating to more than 10,000 for sheet peeling after heating. Namely, the degree of contamination increased 10-fold or more.

**SUMMARY OF THE INVENTION**

Accordingly, one object of the invention is to provide a heat-peelable pressure-sensitive adhesive sheet for electronic parts which after a heat treatment can be easily peeled from the electron parts while causing little contamination.

Another object of the invention is to provide a method of processing an electronic part using the heat-peelable pressure-sensitive adhesive sheet for electronic parts.

Still another object of the invention is to provide an electronic part produced by the processing method.

As a result of intensive investigations to accomplish those aims, it has been found that an electronic part capable of being put to practical use can be produced through processing using a pressure-sensitive adhesive sheet which has been regulated so that when applied to an electronic part and peeled off after a heat treatment, the adhesive sheet causes reduced contamination to the surface of the electronic part. The invention has been completed based on this finding.

The invention provides a heat-peelable pressure-sensitive adhesive sheet for electronic parts which comprises a heat-expandable layer containing heat-expandable microspheres and a non-heat-expandable pressure-sensitive adhesive layer formed on at least one side of the heat-expandable layer, wherein when the pressure-sensitive adhesive sheet is applied, on the side of the non-heat-expandable pressure-sensitive adhesive layer, to a surface of a silicon wafer and is thereafter heated and peeled from the wafer, then the carbon element proportion $R_{C1}$ (%) on this silicon wafer surface as determined by XPS satisfies at least either of the following relationships (1) and (2):

$$R_{C1} \le 50 + R_{C2} \qquad\qquad (1)$$

$$R_{C1} \leq 2.5 R_{Si} \qquad (2)$$

wherein $R_{C2}$ represents the carbon element proportion (%) on the silicon wafer surface as determined by XPS before the application; and $R_{Si}$ represents the silicon element proportion (%) on the silicon wafer surface as determined by XPS after the non-heat-expandable pressure-sensitive adhesive layer applied to the silicon wafer surface is heated and peeled therefrom.

The heat-expandable layer preferably is a heat-expandable pressure-sensitive adhesive layer which has both thermal expansibility and pressure-sensitive adhesive properties and has been formed on at least one side of a substrate. The pressure-sensitive adhesive of the non-heat-expandable pressure-sensitive adhesive layer may be one in which the content of low molecular polymer components having a weight average molecular weight of 100,000 or lower is 15% by weight or lower based on all polymer components, or may be a radiation-curing pressure-sensitive adhesive which is less contaminative. The less contaminative radiation-curing pressure-sensitive adhesive preferably is one which cures so that the content of low-molecular polymer components having a weight average molecular weight of 100,000 or lower in the cured adhesive is 15% by weight or lower based on all polymer components.

The heat-peelable pressure-sensitive adhesive sheet for electronic parts of the invention preferably comprises the heat-expandable layer and non-heat-expandable pressure-sensitive adhesive layer formed in this order on one side of a substrate and further comprises at least a pressure-sensitive adhesive layer formed on the other side of the substrate.

The invention further provides a method of processing an electronic part which comprises: applying the heat-peelable pressure-sensitive adhesive sheet to the electronic part so that the non-heat-expandable pressure-sensitive-adhesive layer comes into contact with the electronic part; and then processing the electronic part. The invention furthermore provides an electronic pin produced through a processing conducted by the method of processing an electronic part.

## BRIEF DESCRIPTION OF THE DRAWINGS

Fig. 1 is a schematic sectional view illustrating part of one embodiment of the heat-peelable pressure-sensitive adhesive sheet for electronic parts of the invention.

Fig. 2 is a schematic sectional view illustrating part of another embodiment of the heat-peelable pressure-sensitive adhesive sheet for electronic parts of the invention.

Fig. 3 is a schematic sectional view illustrating part of still another embodiment of the heat-peelable pressure-sensitive adhesive sheet for electronic parts of the invention.

Description of the Reference Numerals and Signs:

| | |
|---|---|
| 1 | heat-peelable pressure-sensitive adhesive sheet for electronic parts |
| 11 | heat-peelable pressure-sensitive adhesive sheet for electronic parts |
| 12 | heat-peelable pressure-sensitive adhesive sheet for electronic parts |
| 2 | substrate |
| 21 | substrate |
| 22 | substrate |
| 3 | heat-expandable layer |
| 31a | heat-expandable layer |
| 31b | heat-expandable layer |
| 32 | heat-expandable layer |
| 4 | non-heat-expandable pressure-sensitive adhesive layer |
| 41a | non-heat-expandable pressure-sensitive adhesive layer |
| 41b | non-heat-expandable pressure-sensitive adhesive layer |
| 42 | non-heat-expandable pressure-sensitive adhesive layer |
| 5 | liner |
| 51a | liner |
| 51b | liner |
| 52a | liner. |

52b    liner.
6      rubbery organic elastic layer
7      pressure-sensitive adhesive layer

**DETAILED DESCRIPTION OF THE INVENTION**

The heat-peelable pressure-sensitive adhesive sheet for electronic parts of the invention is characterized in that when the pressure-sensitive adhesive sheet is applied, on the side of the non-heat-expandable pressure-sensitive adhesive layer, to a surface of a silicon wafer and is thereafter, heated and peeled from the wafer, then the carbon element proportion $R_{C1}$ (%) on this silicon wafer surface (that surface of the silicon wafer which has been in contact with the non-heat-expandable pressure-sensitive adhesive layer) as determined by XPS satisfies at least either of the following relationships (1) and (2):

$$R_{C1} \leq 50 + R_{C2} \qquad\qquad (1)$$

$$R_{C1} \leq 2.5 R_{Si} \qquad\qquad (2)$$

wherein $R_{C2}$ represents the carbon element proportion (%) on the silicon wafer surface as determined by XPS before the application; and $R_{Si}$ represents the silicon element proportion (%) on the silicon wafer surface (that surface of the silicon wafer which has been in contact with the non-heat-expandable pressure-sensitive adhesive layer) as determined by XPS after the non-heat-expandable pressure-sensitive adhesive layer applied to the silicon wafer surface is heated and peeled therefrom.

The heat-peelable pressure-sensitive adhesive sheet for electronic parts of the invention has at least either of the following two properties. One property is as follows: when the pressure-sensitive adhesive sheet is applied to a surface of a silicon wafer so as to bring the side of the non-heat-expandable pressure-sensitive adhesive layer into contact with the silicon wafer surface and is thereafter heated and peeled off, then the difference between the carbon element proportion $R_{C1}$ (%) on this silicon wafer surface (the surface from which the heat-peelable pressure-sensitive adhesive sheet for electronic parts has been peeled) as determined by XPS and the carbon element proportion $R_{C2}$ (%) on the silicon wafer surface before application of the heat-peelable pressure-sensitive adhesive sheet for electronic parts as determined by XPS ($R_{C1}-R_{C2}$) (sometimes referred to as "$\Delta R_{C1-2}$") is 50 or smaller. The other property is as follows: when the pressure-sensitive adhesive sheet is applied to a surface of a silicon wafer so as to bring the side of the non-heat-expandable pressure-sensitive adhesive layer into contact with the silicon wafer surface and is thereafter heated and peeled off, then the ratio of the carbon element proportion $R_{C1}$ (%) on this silicon wafer surface (the surface from which the heat-peelable pressure-sensitive adhesive sheet for electronic parts has been peeled) as determined by XPS to the silicon element proportion $R_{Si}$ (%) on that silicon wafer surface (the surface from which the heat-peelable pressure-sensitive adhesive sheet for electronic parts applied so as to bring the side of the non-heat-expandable pressure-sensitive adhesive layer into contact with the silicon wafer surface has been peeled after heating) as determined by XPS ($R_{C1}/R_{Si}$) (sometimes referred to as "$R_{C/Si}$") is 2.5 or smaller.

The pressure-sensitive adhesive sheet preferably satisfies both of the relationships (1) and (2). Namely, the pressure-sensitive adhesive sheet preferably has such properties that $\Delta R_{C1-2}$ is 50 or smaller and $R_{C/Si}$ is 2.5 or smaller.

$\Delta R_{C1-2}$ is not particularly limited as long as it is 50 or smaller. For example, it can be selected from the range of from 0 to 50, preferably up to 30 (e.g., from 0.1 to 30), more preferably up to 20 (e.g., from 0.5 to 20), most preferably up to 5 (e.g., from 1 to 5). $\Delta R_{C1-2}$ may be a negative number. When $\Delta R_{C1-2}$ exceeds 50, there are cases where that surface of an electronic part which has been in contact with the non-heat expandable pressure-sensitive adhesive layer (the surface from which the heat-peelable pressure-sensitive adhesive sheet for electronic parts has been peeled) has higher contamination and the electronic part obtained through processing is a defective part unsuitable for practical use.

$R_{C/Si}$ is not particularly limited as long as it is 2.5 or smaller. For example, it can be selected from the range of from 0 to 2.5 [preferably up to 2.25 (e.g., from 0.05 to 2.25), more preferably up to 1.5 (e.g., from 0.1 to 1.5), most preferably up to 0.5 (e.g., from 0.2 to 0.5)]. When $R_{C/Si}$ exceeds 2.5, there are cases where that surface of an electronic part which has been in contact with the non-heat-expandable pressure-sensitive adhesive layer (the surface from which the heat-peelable pressure-sensitive adhesive sheet for electronic parts has been peeled) has higher contamination and the electronic part obtained through processing is a defective part unsuitable for practical use.

Such element proportions (carbon element proportion $R_{C1}$ (%), carbon element proportion $R_{C2}$ (%), silicon element proportion $R_{Si}$ (%), etc.) are determined by XPS (X-ray photoelectron spectroscopy). For example, the determination of carbon element proportion $R_{C1}$ (%) or silicon element proportion $R_{Si}$ (%) by XPS is conducted in the following manner. A heat-peelable pressure-sensitive adhesive sheet for electronic parts is applied to a surface of a silicon wafer so as to bring the non-heat-expandable pressure-sensitive adhesive layer into contact with the silicon wafer surface. This silicon wafer bearing the pressure-sensitive adhesive sheet is heated in a 130°C hot-air drying oven for 3 minutes, and the pressure-sensitive adhesive sheet is then peeled from the silicon wafer. Thereafter, that surface of the silicon wafer from which the pressure-sensitive adhesive sheet has been peeled is examined by X-ray photoelectron spectroscopy using an X-ray photoelectron spectrometer (model "5400" manufactured by ULVAC-PHI, Inc.) under the conditions of an X-ray source of $MgK_\alpha$ 15 kV (300 W), a stage tilt of 45°, and an examination area of 1x3.5 mm. Thus, the carbon element proportion $R_{C1}$ (%) and silicon element proportion $R_{Si}$ (%) can be determined. On the other hand, the determination of carbon element proportion $R_{C2}$ (%) by XPS is, for example, conducted in the following manner. A surface of a silicon wafer to which the heat-peelable pressure-sensitive adhesive sheet for electronic parts has not been applied is examined by X-ray photoelectron spectroscopy using the X-ray photoelectron spectrometer (model "5400" manufactured by ULV-AC-PHI, Inc.) under the conditions of an X-ray source of $MgK_\alpha$ 15 kV (300 W), a stage tilt of 45°, and an examination area of 1x3.5 mm [using the same apparatus and under the same conditions as in the determination of carbon element proportion $R_{C1}$ (%) and silicon element proportion $R_{Si}$ (%)]. Thus, the carbon element proportion $R_{C2}$ (%) can be determined.

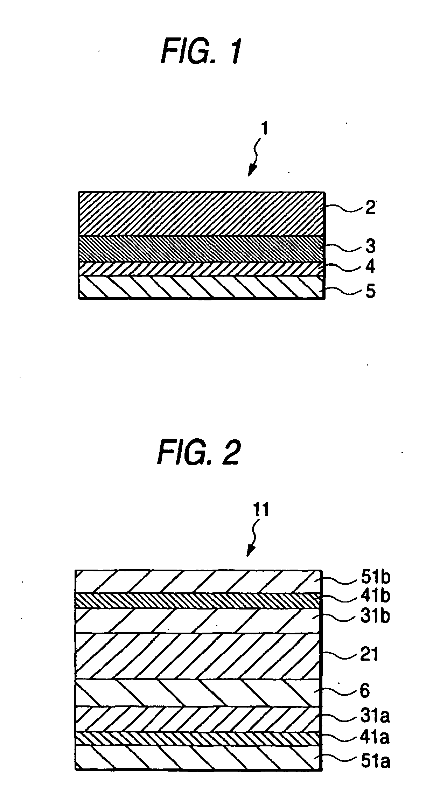

Embodiments for carrying out the invention will be explained below in detail by reference to the drawings according to need. Like members or parts are often designated by like numerals. Fig. 1 is a schematic sectional view illustrating part of one embodiment of the heat-peelable pressure-sensitive adhesive sheet for electronic parts of the invention. In Fig. 1, numeral 1 denotes a heat-peelable pressure-sensitive adhesive sheet for electronic parts, 2 a substrate, 3 a heat-expandable layer, 4 a non-heat-expandable pressure-sensitive adhesive layer, and 5 a liner. The heat-peelable pressure-sensitive adhesive sheet for electronic parts 1 shown in Fig. 1 has a constitution comprising a substrate 2, a heat-expandable layer 3 formed on one side of the substrate 2 and containing heat-expandable microspheres, a non-heat-expandable pressure-sensitive adhesive layer 4 formed on the heat-expandable layer 3, and a liner 5 superposed on the non-heat-expandable pressure-sensitive adhesive layer 4.

Fig. 2 is a schematic sectional view illustrating part of another embodiment of the heat-peelable pressure-sensitive adhesive sheet for electronic parts of the invention. In Fig. 2; numeral 11 denotes a heat-peelable pressure-sensitive adhesive sheet for electronic parts, 21 a substrate, 31a and 31b a heat-expandable layer (these layers are sometimes referred to inclusively as "heat-expandable layers 31"), 41a and 41b a non-heat-expandable pressure-sensitive adhesive layer (these layers are sometimes referred to inclusively as "non-heat-expandable pressure-sensitive adhesive layers 41"), 51a and 51b a liner (these liners are sometimes referred to inclusively as "liners 51"), and 6 a rubbery organic elastic layer. The heat-peelable pressure-sensitive adhesive sheet for electronic parts 11 shown in Fig. 2 has a constitution comprising a rubbery organic elastic layer 6, a-heat-expandable-layer 31a, a non-heat-expandable pressure-sensitive adhesive layer 41a, and a liner 51a which have been superposed in this order on one side of a substrate 21 and further comprising a heat-expandable layer 31b, a non-heat-expandable pressure-sensitive adhesive layer 41b, and a liner 51b which have been superposed in this order on the other side of the substrate 21.

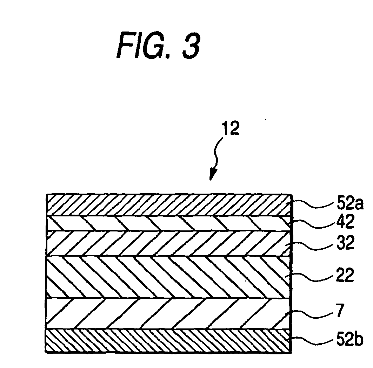

Fig. 3 is a schematic sectional view illustrating part of still another embodiment of the heat-peelable pressure-sensitive adhesive sheet for electronic parts of the invention. In Fig. 3, numeral 12 denotes a heat-peelable pressure-sensitive adhesive sheet for electronic parts, 22 a substrate, 32 a heat-expandable layer, 42 a non-heat-expandable pressuce-sensitive adhesive layer; 52a and 52b a liner (these liners are sometimes referred to inclusively as "liners 52"), and 7 a pressure-sensitive adhesive layer. The heat-peelable pressure-sensitive adhesive sheet for electronic parts 12 shown in Fig. 3 has a constitution comprising a heat-expandable layer 32, a non-heat-expandable pressure-sensitive adhesive layer 42, and a liner 52a which have been superposed in this order on one side of a substrate 22 and further comprising a pressure-sensitive adhesive layer 7 and a liner 52b which have been superposed in this order on the other side of the substrate 22.

The heat-peelable pressure-sensitive adhesive sheets for electronic parts shown in Figs. 1 to 3 have a constitution which includes at least one heat-expandable layer having a non-heat-expandable pressure-sensitive adhesive layer formed on one side thereof. In particular, the heat-peelable pressure-sensitive adhesive sheet for electronic parts shown in Fig. 2 has a constitution in which a heat-expandable layer and a non-heat-expandable pressure-sensitive adhesive layer have been formed in this order on one side of the substrate through a rubbery organic elastic layer and at least a pressure-sensitive adhesive layer has been formed on the other side (a heat-expandable layer and a non-heat-expandable-pressure-sensitive adhesive layer have been formed in this order on the other side). Furthermore, the heat-peelable pressure-sensitive adhesive sheet for electronic parts shown in Fig. 3 has a constitution in which a heat-expandable layer and a non-heat-expandable pressure-sensitive adhesive layer have been formed in this order and at least a pressure-sensitive adhesive layer has been formed on the other side. The substrate, liner, rubbery organic elastic layer, and pressure-sensitive adhesive layer each may optionally be disposed.

Heat-Expandable Layer:

The heat-expandable layers (3, 31, and 32) at least contain heat-expandable microspheres for imparting thermal expansibility. Because of this, when the pressure sensitive adhesive sheet is applied to an electronic part and the heat-expandable layer is heated at any desired time thereafter, then the heat-expandable microspheres are foamed and/or expanded and the heat-expandable layer hence expands accordingly. Due to this expansion of the heat-expandable layer, that surface of the non-heat-expandable pressure-sensitive adhesive layer which is in contact with the electronic part comes to have uneven surface, whereby the adhesion area between the non-heat-expandable pressure-sensitive adhesive layer and the electronic part is reduced and the adhesive force of the non-heat-expandable pressure-sensitive adhesive layer decreases accordingly. As a result, the pressure-sensitive adhesive sheet can be easily peeled from the electronic part. Consequently, the heat-peelable pressure-sensitive adhesive sheet for electronic parts which has been applied to an electronic part can be made easily peelable from the electronic part by heating the heat-expandable layer at any time.

Heat-Expandable Microspheres:

The heat-expandaMe microspheres can be suitably selected from known heat-expandable microspheres. The heat-expandable microspheres that can be advantageously used are a foaming agent which has been microencapsulated. Examples of such heat-expandable microspheres include microcapsules obtained by encapsulating a substance which readily gasifies and expands upon heating, such as isobutane, propane or pentane, in elastic shells. In many cases, the shells are made of a hot-melt material or a material which breaks upon thermal expansion. Examples of the shell-forming material include vinylidene chloride/acrylonitrile copolymers, poly(vinyl alcohol), poly(vinyl butyral), poly(methyl methacrylate), polyacrylonitrile, poly(vinylidene chloride), and polysulfones. The heat-expandable microspheres can be produced by a conventional method such as coacervation or interfacial polymerization. There are commercial products of heat-expandable microspheres, e.g., MATSUMOTO MICROSPHERE (trade name; manufactured by Matsumoto Yushi Seiyaku K.K.).

When a foaming agent which has not been microeneapsulated is used in place of heat-expandable microspheres, there are cases where the heat-peelable pressure-sensitive adhesive sheet, when applied to an electronic part and heated and peeled off thereafter, causes enhanced contamination to the surface of the electronic part probably because the non-heat-expandable pressure-sensitive adhesive layer undergoes cohesive failure due to the foaming agent. Namely, this pressure-sensitive adhesive sheet is less effective in inhibiting contamination enhancement. In this case, the heat-peelable pressure-sensitive adhesive sheet may be unable to satisfy the relationships (1) and/or (2).

From the standpoint of efficiently and stably lowering the adhesive force of the non-heat-expandable pressure-sensitive adhesive layer by a heat treatment, it is preferred to use heat-expandable microspheres having such a moderate strength that they do not break until the volume expansion ratio thereof reaches at least 5 times, preferably at least 7 times, more preferably at least 10 times.

The particle diameter (average particle diameter) of the heat-expandable microspheres in the invention can be suitably selected according to the thickness of the heat-expandable layer, etc. For example, the average particle diameter of the heat-expandable microspheres can be selected from the range of up to 100 $\mu$m, preferably up to 80 $\mu$m, more preferably from 1 to 50 $\mu$m, most preferably from 1 to 30 $\mu$m. The particle diameter of the heat-expandable microspheres may be regulated during the formation thereof. Alternatively, it may be regulated after microsphere formation by a technique such as classification.

The heat-expandable layer is not particularly limited as long as it is a layer containing heat-expandable microspheres. For example, the layer may be constituted of a mixture of a binder and heat-expandable microspheres. Usually, the heat-expandable microspheres in this mixture layer have been uniformly or almost uniformly dispersed in the binder. The binder that can be used are, for example, polymers, waxes, and the like which allow the heat-expandable microspheres to foam and/or expand upon heating. Of those, preferable materials for use as the binder are ones which restrain, in the lowest possible degree, the foaming and/or expansion of the heat-expandable microspheres during heating. From, the standpoints of the thermal expansibility of the heat-expandable microspheres, controllability of the pressure-sensitive adhesive properties (e.g., adhesive force) of the non-heat-expandable pressure-sensitive adhesive layer in application to: electronic parts, etc., a pressure-sensitive adhesive can be advantageously used as the binder. When used as the binder, a pressure-sensitive adhesive can not only function as a binder but also perform its intrinsic function as a pressure-sensitive adhesive. A pressure-sensitive adhesive may be used the purpose of merely imparting pressure-sensitive adhesive properties, not as a binder.

The amount of the heat-expandable microspheres incorporated can be suitably determined according to the desired expansion ratio, the desired degree of decrease of the adhesive force of the non-heat-expandable pressure-sensitive adhesive layer, etc. However, the microspheres are incorporated, for example, in an amount of generally from 1 to 150 parts by weight, preferably from 10 to 130 parts by weight, more preferably from 25 to 100 parts by weight, per 100 parts by weight of the polymer ingredient constituting the heat-expandable layer (e.g., the base polymer of the pressure-sensitive adhesive as a binder).

Pressure-Sensitive Adhesive:

Examples of the pressure-sensitive adhesive used (as a binder or another ingredient) in the heat-expandable layers (3, 31, and 32) include known pressure-sensitive adhesives such as rubber-based pressure-sensitive adhesives, acrylic pressure-sensitive adhesives, vinyl alkyl ether-based pressure-sensitive adhesives, silicone-based pressure-sensitive adhesives, polyester-based pressure-sensitive adhesives, polyamide-based pressure-sensitive adhesives, urethane-based pressure-sensitive adhesives, fluoropolymer-based pressure-sensitive adhesives, styrene/diene block copolymer-based pressure-sensitive adhesives, and pressure-sensitive adhesives having improved creep characteristics obtained by incorporating a hot-melt resin having a melting point of about 200°C or lower into these pressure-sensitive adhesives. Such pressure-sensitive adhesives can be used alone or in combination of two or more thereof. (See, for example, Japanese Patent Laid-Open Nos. 56-61468, 61-174857, 63-17981, and 56-13040) A radiation-curing pressure-sensitive adhesive (or energy ray-curing pressure-sensitive adhesive) can also be used. The pressure-sensitive adhesive may contain appropriate additives besides polymeric ingredients including the pressure-sensitive adhesive ingredient (base polymer) according to the kind of the pressure-sensitive adhesive, etc. Examples of the additives include crosslinking agents (e.g., polyisocyanates and melamine alkyl ethers), tackifiers (e.g., resins which are solid, semisolid, or liquid at ordinary temperature, such as rosin derivative resins, polyterpene resins, petroleum resins, and oil-soluble phenol resins), plasticizers, fillers, and antioxidants.

Preferred examples of the pressure-sensitive adhesive generally include rubber-based pressure-sensitive adhesives containing natural rubber or any of various synthetic rubbers (e.g., a polyisoprene rubber, styrene/butadiene rubber, styrene/isoprene/styrene block copolymer rubber, styrene/butadiene/styrene block copolymer rubber, reclaimed rubber, butyl rubber, and polyisobutylene) as the base polymer; and acrylic pressure-sensitive adhesives containing as the base polymer an acrylic polymer (homopolymer or copolymer) formed from one or more monomers comprising one or more alkyl (meth)acrylates. Examples of the alkyl (meth)acrylates for the acrylic pressure-sensitive adhesives include $C_{1-20}$ alkyl esters of(meth)acrylic acid, such as the methyl ester, ethyl ester, propyl ester, isopropyl ester, butyl ester, isobutyl ester, s-butyl ester, t-butyl ester, pentyl ester, hexyl ester, heptyl ester, octyl ester, 2-ethylhexyl ester, isooctyl ester, nonyl ester, isononyl ester, decyl ester, isodecyl ester, undecyl ester, dodecyl ester, tridecyl ester, tetradecyl ester, pentadecyl ester, hexadecyl ester, heptadecyl ester, octadecyl ester, nonadecyl ester, and eicosyl ester of (meth)acrylic acid. $C_{4-18}$ alkyl (linear or branched alkyl) esters of (meth)acrylic acid are preferable.

The acrylic polymer may contain units derived from one or more other monomers copolymerizable with those alkyl (meth)acrylates so as to improve cohesive force, heat resistance, crosslinkability, or other properties according to need. Examples of such monomers include carboxyl-containing monomers such as acrylic acid, methacrylic acid, carboxyethyl acrylate, carboxypentyl acrylate, itaconic acid, maleic acid, fumaric acid, and crotonic acid; acid anhydride monomers such as maleic anhydride and itaconic anhydride; hydroxyl-containing monomers such as hydroxyethyl (meth) acrylate; hydroxypropyl (meth)acrylate, hydroxybutyl (meth)acrylate, hydroxyhexyl (meth)acrylate, hydroxyoctyl (meth) acrylate, hydroxydecyl (meth)acrylate, hydroxylauryl (meth)acrylate, and (4-hydroxymethylcyclohexyl)methyl methacrylate; sulfo-containing monomers such as styrenesulfonic acid, allylsulfonic acid, 2-(meth)acrylamido-2-methylpropanesulfonic acid, (meth)acrylamidopropanesulfonic acid, sulfopropyl (meth)acrylate, and (meth)acryloyloxynaphthalenesulfonic acid; phosphate group-containing monomers such as 2-hydroxyethylacryloyl phosphate; (N-substituted) amide monomers such as (meth)acrylamide, N,N-dimethyl(meth)acrylamide, N-butyl(meth)acrylamide, N-methylol (meth)acrylamide, and N-methylolpropane(meth)acrylamide; aminoalkyl (meth)acrylate monomers such as aminoethyl (meth)acrylate, NN-dimethylaminoethyl (meth)acrylate, and t-butylaminoethyl (meth)acrylate; alkoxyalkyl (meth)acrylate monomers such as methoxyethyl (meth)acrylate and ethoxyethyl (meth)acrylate; maleimide monomers such as N-cyclohexylmaleimide, N-isopropylmaleimide, N-laurylmaleimide, and N-phenylmaleimide; itaconimide monomers such as N-methylitaconimide, N-ethylitaconimide, N-butylitaconimide, N-octylitaconimide, N-2-ethylhexylitaconimide, N-cyclohexylitaconimide, and N-laurylitaconimide; succinimide monomers such as N-(meth)acryloyloxymethylenesuccinimide, N-(meth)acryloyl-6-oxyhexamethylenesuccinimide, and N-(meth)acryloyl-8-xyoctamethylenesuccinimide; vinyl monomers such as vinyl acetate, vinyl propionate, N-vinylpyrrolidone, methylvinylpyrrolidone, vinylpyridine, vinylpiperidone, vinylpyrimidine, vinylpiperazine, vinylpyrazine, vinylpyrrole, vinylimidazole, vinyloxazole, vinylmorpholine, N-vinylcarboxamides, styrene, $\alpha$-methylstyrene, and N-vinylcaprolactam; cyanoacrylate monomers such as acrylonitrile and methacrylonitrile; epoxy-containing acrylic monomers such as glycidyl (meth)acrylate; glycol acrylate monomers such as polyethylene glycol (meth)acrylate, polypropylene glycol (meth)acrylate, methoxyethylene glycol (meth)acrylate, and methoxypolypropylene glycol (meth)acrylate; acrylate monomers having a heterocycle, one or more halogen or silicon atoms; or the like, such as tetrahydrofurfuryl (meth)acrylate, fluorinated (meth)acrylates, and silicone (meth)acrylates; polyfunctional monomers such as hexanediol di(meth)acrylate, (poly)ethylene glycol di(meth)acrylate, (poly)propylene glycol di(meth)acrylate, neopentyl glycol di(meth)acrylate, pentaerythritol di(meth)acrylate, trimethylolpropane tri(meth)acrylate, pentaerythritol, tri(meth)acrylate, dipentaerythritol hexa(meth)acrylate, epoxy acrylates, polyester acrylates, urethane acrylates, divinylbenzene, butyl di(meth)acrylate, and hexyl di(meth)acrylate; olefin monomers such as isoprene, butadiene, and isobutylene; and vinyl ether monomers such as vinyl ether. Those monomers can be used alone or in combination of two or more thereof.

From the standpoint of a balance between moderate adhesive force before heat treatment and a decrease in adhesive force through heat treatment, a preferred pressure-sensitive adhesive is one which comprises as the base polymer a polymer having a dynamic modulus of elasticity of from 50,000 to 10,000,000 dyn/cm$^2$ in the temperature range of from room temperature to 150°C.

The heat-expandable layer can be formed by, for example, a conventional method which comprises mixing heat-expandable microspheres with a binder, e.g., a pressure-sensitive adhesive, and with optional ingredients such as a solvent and other additives and forming the mixture into a sheet-form layer. Specifically, the heat-expandable layer can be formed by, for example, a method in which a mixture comprising heat-expandable microspheres, a binder, e.g., a pressure-sensitive adhesive, and optional ingredients such as a solvent and other additives is applied to a substrate or a rubbery organic elastic layer, or by a method in which the mixture is applied to an appropriate liner (e.g., release paper) to form a heat-expandable layer and this layer is transferred (shifted) to a substrate or a rubbery organic elastic layer. The heat-expandable layer may have a single-layer structure or multilayer structure.

The thickness of the heat-expandable layer can be suitably selected according to the desired degree of reduction in adhesive force, etc. For example, the thickness thereof is about 300 μm or smaller, preferably 200 μm or smaller, more preferably 150 μm or smaller. In case where the thickness thereof is too large, the non-heat-expandable pressure-sensitive adhesive layer is apt to suffer cohesive failure when the pressure-sensitive adhesive sheet is peeled off after a heat treatment. As a result, the pressure-sensitive adhesive partly remains on the electronic part to contaminate it. On the other hand, in case where the thickness of the heat-expandable layer is too small, the heat-expandable layer deforms insufficiently through a heat treatment and, hence, the adhesive force cannot be smoothly lowered. In addition, such too small thicknesses may necessitate use of heat-expandable microcapsules having an excessively small particle diameter. From these standpoints, the thickness of the heat-expandable layer is preferably 2 μm or larger, more preferably 5 μm or larger, most preferably 10 μm or larger.

Non-Heat-Expandable Pressure-Sensitive Adhesive Layer:

The non-heat-expandable pressure-sensitive adhesive layers (4, 41, and 42) are pressure-sensitive adhesive layers through which the pressure-sensitive adhesive sheets are applied to electronic parts. These are layers having no thermal expansibility. The non-heat-expandable pressure-sensitive adhesive layers formed serve, for example, to secure adhesion to electronic parts and prevent the electronic parts from suffering enhanced contamination (in particular, fine contaminants) when the pressure-sensitive adhesive sheets are treated with heat for lowering the adhesive force. In the case of a pressure-sensitive adhesive sheet having two non-heat-expandable pressure-sensitive adhesive layers like that shown in Fig. 2, at least either of the non-heat-expandable pressure-sensitive adhesive layers can be used for application to a surface of an electronic part. The non-heat-expandable pressure-sensitive adhesive layer may have a single-layer structure of multilayer structure.

The pressure-sensitive adhesive used for constituting the non-heat-expandable pressure-sensitive adhesive layer is not particularly limited and can be suitably selected according to the desired pressure-sensitive adhesive properties (e.g., adhesive force) in application to electronic parts. For example, pressure-sensitive adhesives which are known or in common use can be used, such as the pressure-sensitive adhesives enumerated hereinabove as examples of the pressure-sensitive adhesive for the heat-expandable layer (e.g., rubber-based pressure-sensitive adhesives, acrylic pressure-sensitive adhesives, vinyl alkyl ether-based pressure-sensitive adhesives, silicone-based pressure-sensitive adhesives, polyester-based pressure-sensitive adhesives, polyamide-based pressure-sensitive adhesives, urethane-based pressure-sensitive adhesives, fluoropolymer-based pressure-sensitive adhesives, styrene/diene block copolymer-based pressure-sensitive adhesives, pressure-sensitive adhesives having improved creep characteristics, and radiation-curing pressure-sensitive adhesives). The pressure-sensitive adhesive used for constituting the non-heat-expandable pressure-sensitive adhesive layer is preferably one which restrains, in the lowest possible degree, the thermal deformation of the heat-expandable layer.

From the standpoint of satisfying the relationships (1) and/or (2), it is preferred to use a less contaminative pressure-sensitive adhesive as the pressure-sensitive adhesive constituting the non-heat-expandable pressure-sensitive adhesive layer. Examples of the less contaminative pressure-sensitive adhesive include rubber-based or acrylic pressure-sensitive adhesives in which the content of low molecular polymer components having a weight-average molecular weight of 100,000 or lower is 15% by weight or lower, preferably 10% by weight or lower, more preferably 5% by weight or lower, most preferably 1% by weight of lower, based on all polymer components. Examples thereof further include radiation-curing pressure-sensitive adhesives which cure so that the content of low molecular polymer components having a weight average molecular weight of 100,000 or lower in the cured adhesives is 15% by weight or lower, preferably 10% by weight or lower, more preferably 5% by weight or lower, most preferably 1 % by weight or lower, based on all polymer components.

In the case where an acrylic pressure-sensitive adhesive, for example, is produced as such a pressure-sensitive adhesive having a low content of low-molecular polymer components, the following methods can be employed. However, usable methods are not limited thereto.

(A) An acrylic polymer obtained by, e.g., polymerization is introduced into a solvent in which high-molecular polymer components do not dissolve, such as heptane (aliphatic hydrocarbon). This mixture is stirred to thereby dissolve low-molecular polymer components of the acrylic polymer in the solvent and precipitate high-molecular polymer components of the acrylic polymer. This precipitate is taken out. Thus, an acrylic polymer having a lower content of low-molecular polymer components is obtained. Repeating this operation gives an acrylic polymer having an even lower content of low molecular polymer components.

(B) Ordinary radical polymerization results in the formation of low molecular polymer components and in a wide molecular weight distribution. Consequently, a polymerization method resulting in a narrow molecular weight distribution, such as living radical polymerization or anionic polymerization, is used to obtain an acrylic polymer having an even lower content of low molecular polymer components.

(C) Ordinary radical polymerization gives high molecular polymer components in an initial stage and yields low molecular polymer components in a later stage of the polymerization. Consequently, the polymer is taken out of the polymerization system at the time when the conversion is from 85 to 97%. Thus, an acrylic polymer having an even lower content of low molecular polymer components is obtained. In this method in which the polymer being yielded is taken out of the polymerization system at the time when the conversion is from 85 to 97%, low-molecular polymer components and the monomer ingredients remaining in the polymerization system are removed, for example, by using the solvent, e.g., heptane, to remove the monomers or by drying the polymer at high temperature to remove the monomers by vaporization.

In the case of pressure-sensitive adhesives other than acrylic pressure-sensitive adhesives, substantially the same methods as the methods described above can also be used to prepare polymers having a low content of low-molecular polymer components.

The pressure-sensitive adhesive (in particular, low contaminative pressure-sensitive adhesive) used for constituting the non-heat-expandable pressure-sensitive adhesive layer preferably contains a crosslinking agent. Crosslinking the polymer ingredient as a pressure-sensitive adhesive ingredient with a crosslinking agent gives a pressure-sensitive adhesive layer having further lower content of low-molecular polymer components. This crosslinking agent is not particularly limited. Examples thereof include isocyanate crosslinking agents such as tolylene diisocyanate, trimethylolpropane triisocyanate, and diphenylmethane diisocyanate; epoxy crosslinking agents such as polyethylene glycol diglycidyl ether, diglycidyl ether, and trimethylolpropane triglycidyl ether; melamine crosslinking agents such as melamine alkyl ethers; metal salt crosslinking agents; metal chelate crosslinking agents; amino crosslinking agents; peroxide crosslinking agents; and coupling crosslinking agents such as silane coupling agents.

The radiation-curing pressure-sensitive adhesive is a pressure-sensitive adhesive which not only has pressure-sensitive, adhesive properties but can cure by the action of radiation (or energy ray). Through this curing with a radiation, the pressure-sensitive adhesive can have reduced adhesive force. Namely, in the radiation-curing pressure-sensitive adhesive, the crosslinking/curing is effective in diminishing the contaminants to be transferred to electronic parts and in lowering the adhesive force according to need.

Examples of the radiation-curing pressure-sensitive adhesive include: a radiation-curing pressure-sensitive adhesive which comprises a base (pressure-sensitive adhesive) and a compound having crosslinking functional groups, e.g., a polyfunctional monomer, incorporated in the base and optionally further contains a radiation polymerization initiator; and a radiation-curing pressure-sensitive adhesive which comprises a pressure-sensitive adhesive comprising a polymer ingredient formed by copolymerization with a compound having crosslinking functional groups, e.g., a polyfunctional monomer, as a monomer ingredient and optionally further contains a radiation polymerization initiator.

Preferable radiation-curing pressure-sensitive adhesive is a radiation-curing pressure-sensitive adhesive which comprises a base (pressure-sensitive adhesive) and a compound having crosslinking functional groups, e.g., a polyfunctional monomer, incorporated in the base and optionally further contains a radiation polymerization initiator. Examples of the base include pressure-sensitive adhesives based on a rubber such as natural rubber or a synthetic rubber; pressure-sensitive adhesives comprising a silicone rubber; acrylic pressure-sensitive adhesives comprising a homo- or copolymer of one or more of alkyl (meth)acrylates (e.g., $C_{1-20}$ alkyl esters of (meth)acrylic acid, such as the methyl ester, ethyl ester, propyl ester, isopropyl ester, butyl ester, isobutyl ester, hexyl ester, octyl ester, 2-ethylhexyl ester, isooctyl ester, isodecyl ester, and dodecyl ester) or comprising a copolymer of one or more of such alkyl (meth)acrylates with one or more other monomers (e.g., carboxyl-containing or acid anhydride monomers such as acrylic acid, methacrylic acid, itaconic acid, maleic acid, fumaric acid, and maleic anhydride; hydroxyl-containing monomers such as 2-hydroxyethyl (meth)acrylate; sulfo-containing monomers such as styrenesulfonic acid; phosphate group-containing monomers such as 2-hydroxyethylacryloyl phosphate; amide group-containing monomers such as (meth)acrylamide; amino group-containing monomers such as aminoethyl (meth)acrylate; alkoxy-containing monomers such as methoxyethyl (meth) acrylate; imide group-containing monomers such as N-cyclohexylmaleimide; vinyl esters such as vinyl acetate; vinyl-containing heterocyclic compounds such as N-vinylpyrrolidone; styrene monomers such as styrene and $\alpha$-methylstyrene; cyano-containing monomers such as acrylonitrile; epoxy-containing acrylic monomers such as glycidyl (meth)acrylate; and vinyl ether monomers such as vinyl ether); and polyurethane-based pressure-sensitive adhesives. Preferred examples of the base include acrylic pressure-sensitive adhesives. The base may consist of one ingredient or may be composed of two or more ingredients.

The compound having crosslinking functional groups may be either a radiation-curing low molecular compound or a radiation-curing resin. A radiation-curing low molecular compound and a radiation-curing resin may be used in combination, or only either of these may be used. Radiation-curing low molecular compounds or radiation-curing resins may be used alone or in combination of two or more thereof.

The radiation-curing low-molecular compounds are not particularly limited as long as they can cure by the action of energy rays (radiations) such as visible rays, ultraviolet, and electron beams. However, ones which enable a three-dimensional network structure to be efficiently formed in the non-heat-expandable pressure-sensitive adhesive layer upon irradiation with energy rays are preferred. Examples of the radiation-curing low molecular compounds include trimethylolpropane triacrylate, tetramethylolmethane tetraacrylate, pentaerythritol triacrylate, pentaerythritol tetraacrylate, dipentaerythritol monohydroxypentaacrylate, dipentaerythritol hexaacrylate, 1,4-butylene glycol diacrylate, 1,6-hexanediol diacrylate, and hexaacrylate, glycol diacrylate, 1,6-hexanediol diacrylate, and polyethylene glycol diacrylate. Examples of the radiation-curing resins include polymers or oligomers having photosensitive reactive groups. Specific examples thereof include (meth)acrylate polymers having (meth)acryloyl groups at molecular ends, such as ester (meth)acrylates, urethane (meth)acrylates, epoxy (meth)acrylates, melamine (meth)acrylates, and acrylic resin (meth)acrylates, thiol-ene addition type resins having allyl groups at molecular ends, resins undergoing cationic photopolymerization, cinnamoyl-containing polymers such as poly(vinyl cinnamate), diazotized aminonovolac resins, and acrylamide polymers. Examples thereof further include polymers which react by the action of high-energy rays, such as epoxidized polybutadiene, unsaturated polyesters, poly(glycidyl methacrylate), polyacrylamide, and polyvinylsiloxanes. In the case of using a radiation-curing resin, the base is not essential.

The amount of the compound having crosslinking functional groups to be incorporated is, for example, from about 5 to 500 parts by weight, preferably from about 15 to 300 parts by weight, more preferably from about 20 to 150 parts by weight, per 100 parts by weight of the base.

An ultraviolet (UV)-reactive pressure-sensitive adhesive polymer may also be used as the radiation-curing pressure-sensitive adhesive. Examples of the ultraviolet-reactive pressure-sensitive adhesive polymer include photosensitive acrylic pressure-sensitive adhesives comprising an acrylic polymer into the molecule of which a compound containing a photosensitive functional group has been incorporated through a chemical reaction with an active functional group such as hydroxyl or carboxyl. Ultraviolet-reactive pressure-sensitive adhesive polymers can be used alone or as a mixture of two or more thereof.

Examples of the radiation polymerization initiator include acetophenone type initiators such as 4-(2-hydroxyethoxy)phenyl 2-hydroxy-2-propyl ketone, $\alpha$-hydroxy-$\alpha,\alpha$'-dimethylacetophenone, methoxyacetophenone, 2,2-dimethoxy-2-phenylacetophenone, 2,2-diethoxyacetophenone, 1-hydroxycyclohexyl phenyl ketone, and 2-methyl-1-[4-(methylthio)phenyl]-2-morpholinopropane-1, benzoin ether initiators such as benzoin ethyl ether, benzoin isopropyl ether, and anisoin methyl ether; $\alpha$-ketol compounds such as 2-methyl-2-hydroxypropiophenone; ketal compounds such as benzyl dimethyl ketal; aromatic sulfonyl chloride compounds such as 2-naphthalenesulfonyl chloride; optically active oxime compounds such as 1-phenone-1,1-propahedione-2-(o-ethoxycarbonyl) oxime; benzophenone compounds such as benzophenone, benzoylbenzoic acid, and 3,3'-dimethyl-4-methoxybenzophenone; thioxanthone compounds such as thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, and 2,4-diisopropylthioxanthone; and camphorquinone, halogenated ketones, acyl phosphinoxides, and acyl phosphonates.

Besides the ingredients described above, appropriate additives may be incorporated into the radiation-curing pressure-sensitive adhesive so as to obtain appropriate viscoelasticity before and after curing with radiation. Examples of such additives include heat polymerization initiators, crosslinking agents, tackifiers, and vulcanizing agents. A radiation, polymerization accelerator may be used in combination with the radiation polymerization initiator.

The radiation-curing pressure-sensitive adhesive used in the invention preferably is a radiation-curing acrylic pressure-sensitive adhesive comprising an acrylic pressure-sensitive adhesive as the base.

For forming the non-heat-expandable pressure-sensitive adhesive layer according to the invention, a pressure-sensitive adhesive containing known or ordinary additives such as, e.g., a plasticizer, filler, surfactant, antioxidant, and tackifier may be used. However, in the case where transfer of such additives to electronic parts poses a problem, a pressure-sensitive adhesive containing no additives may be used in order to effectively make the pressure-sensitive adhesive layer less contaminative.

The non-heat-expandable pressure-sensitive adhesive layer can be formed by an ordinary method. For example, it can be formed by a method in which a liquid pressure-sensitive adhesive is applied to the heat-expandable layer or by a method which comprises forming a non-heat-expandable pressure-sensitive adhesive layer on an appropriate liner by that method and transferring (shifting) the adhesive layer to the heat-expandable layer.

The thickness of the non-heat-expandable pressure-sensitive adhesive layer is not particular limited, and can be suitably selected according to the intended use of the pressure-sensitive adhesive sheet, desired degree of reduction in adhesive force by heating, etc. From the standpoints of preventing the non-heat-expandable pressure-sensitive adhesive layer from suffering cohesive failure during thermal deformation (and preventing the adhesive layer from leaving a larger amount of contaminants on the surface of an electronic part) and of enabling the pressure-sensitive adhesive layer to conform to the irregularity-forming deformation of the heat-expandable layer (and causing the force of adhesion to the electronic part to be reduced or lost); etc., the thickness of the non-heat-expandable pressure-sensitive adhesive layer may be, for example, about 20 $\mu$m or smaller, preferably from about 0.1 to 10 $\mu$m, more preferably from about 1 to 50 $\mu$m. In case where the thickness of the non-heat-expandable pressure-sensitive adhesive layer is too large, this adhesive layer is less apt to conform to the irregularity-forming thermal deformation of the heat-expandable layer. In case where the thickness of the non-heat-expandable pressure-sensitive adhesive layer is too small, this adhesive layer is apt to have insufficient adhesive force or to suffer cohesive failure during the irregularity-forming thermal deformation of the heat-expandable layer.

Substrate:

As shown in Figs. 1 and 2, a substrate (1, 11, or 12) can be used in the invention according to need. Consequently, the pressure-sensitive adhesive sheet need not always have a substrate. A substrate can be used as a supporting base for the heat-expandable layer or other layers. Use of a substrate (as a supporting base) improves the handleability of the heat-peelable pressure-sensitive adhesive sheet because the heat-expandable layer and hence the non-heat-expandable pressure-sensitive adhesive layer are supported and reinforced by the base. As a result, application to an electronic part, peeling from the electronic part after heating, and other operations can be efficiently conducted. The substrate may have a single-layer structure or multilayer constitution.

The substrate that can be used is an appropriate thin sheet material. Examples thereof include paper-based substrates such as papers; fibrous substrates such as fabrics, non-woven fabrics, and nets; metallic substrates such as metal foils and metal sheets; plastic substrates such as plastic films and sheets; rubber substrates such as rubber sheets; foams such as foamed sheets; and laminates of these (in particular, laminates of a plastic substrate with another substrate and laminates of plastic films (or sheets)). From the standpoints of handleability after heating, etc., it is preferred to use a highly heat-resistant substrate which does not melt at the temperature at which the heat-expandable layer is to be heat-treated. Preferred substrates include plastic substrates such as plastic films and sheets. Examples of the materials of such plastic substrates include olefin resins formed from one or more monomers comprising an $\alpha$-olefin, such as polyethylene (PE), polypropylene (PP), ethylene/propylene copolymers, and ethylene/vinyl acetate copolymers (EVA); polyester such as poly(ethylene terephthalate) (PET), poly(ethylene naphthalate) (PEN), and poly(butylene terephthalate) (PBT); poly(vinyl chloride) (PVC); poly(phenylene sulfide) (PPS); amide resins such as polyamides (nylons) and wholly aromatic polyamides (aramids); and polyetheretherketones (PEEK). In the case where a plastic substrate is used; this substrate may have undergone stretching or the like so as to regulate its deformation properties such as elongation. When a radiation-curing substance is used in the heat-expandable layer or non-heat-expandable pressure-sensitive adhesive layer, it is preferred to employ a substrate which does not inhibit the radiation from passing therethrough.

The thickness of the substrate can be suitably selected according to the desired strength and flexibility, intended use, etc. For example, the thickness thereof is generally about 1,000 $\mu$m or smaller (e.g., from 1 to 1,000 $\mu$m), preferably from about 1 to 500 $\mu$m, more preferably from about 3 to 300 $\mu$m, most preferably from about 5 to 250 $\mu$m. However, the substrate thickness is not limited thereto.

The surface of the substrate may have undergone an ordinary surface treatment so as to have enhanced adhesiveness to the heat-expandable layer or other layers. Examples of the surface treatment include chemical or physical oxidation treatments such as chromic acid treatment, exposure to ozone, exposure to flame, exposure to high-voltage shock, and treatment with an ionizing radiation. The substrate surface may have undergone coating treatment with, e.g., a primer. Furthermore, the substrate surface may have undergone coating treatment with, e.g., a release agent such as a silicone resin or fluororesin so as to have peelability from the heat-expandable layer or other layers.

The substrate can be a poorly bondable substrate or a strongly bondable substrate. Examples of the poorly bondable substrate include substrates made of non-polar polymers such as olefin resins, e.g., polyethylene and polypropylene, and substrates coated with the release agent. Examples of the strongly bondable substrate include substrates made of highly polar polymers such as polyesters and substrates which have undergone a surface oxidation treatment by any of the chemical and physical methods.

The poorly bondable substrate is used as a substrate for a substrate-peelable pressure-sensitive adhesive sheet, in which the substrate and the layer overlying the same can be easily peeled from each other. This substrate-peelable pressure-sensitive adhesive sheet can, for example, be used in the following manner. The pressure-sensitive adhesive sheet is applied to an electronic part a, and the substrate is then peeled off to leave the heat-expandable layer on the electronic part a. Thereafter, another electronic part b is adhered to this heat-expandable layer. Namely, the substrate-peelable pressure-sensitive adhesive sheet can be used as an adhesive for temporary fixation. In this case, when the adhered state is desired to be ended, the heat-expandable layer is heated, whereby the electronic parts a and b can be easily separated from each other. On the other hand, the strongly bondable substrate is used as a substrate for a substrate-fixed pressure-sensitive adhesive sheet, in which the substrate is strongly bonded to the layer overlying the same. Such a substrate-fixed pressure-sensitive adhesive sheet can be adhered to an electronic part at a predetermined adhesive force. When the adhered state of this adhesive sheet is desired to be ended, the adhesive sheet is heated, whereby it can be easily peeled or separated from the electronic part.

In the invention, a heat-expandable layer can be formed on at least one side (on one side or on each side) of the substrate as shown in Figs. 1 to 3. The pressure-sensitive adhesive sheet can have a constitution having a substrate embedded in a heat-expandable layer.

One or more interlayers can be formed between the substrate and each heat-expandable layer. Examples of the interlayers include a release agent coating layer for imparting peelability and a primer coating layer for improving adhesiveness, as stated above. Examples of the interlayers other than the release agent coating layer and primer coating layer include a layer for imparting satisfactory deformability, a layer for increasing the area of adhesion to electronic parts; a layer for improving adhesive force, a layer for improving conformability to the surface shapes of electronic parts, a layer for improving suitability for a heat treatment for lowering adhesive force, and a layer for improving peelability from electronic parts after heating.

Rubbery Organic Elastic Layer:

From the standpoints of imparting deformability, improving peelability after heating; etc., a rubbery organic elastic layer 6 can, for example, be formed in the invention as an interlayer between the substrate and a heat-expandable layer as shown in Fig. 2. The rubbery organic elastic layer 6 functions to enable the surface of the heat-peelable pressure-sensitive adhesive sheet to satisfactorily conform to the surface shape of an electronic part, when the pressure-sensitive adhesive sheet is bonded to the electronic part, and to thereby have an increased adhesion area. The elastic layer 6 further functions, when the pressure-sensitive adhesive sheet is heated and peeled from the electronic part, to highly satisfactorily (precisely) control the thermal expansion of the heat-expandable layer and thereby enable the heat-expandable layer to evenly expand preferentially in the thickness direction. This rubbery organic elastic layer 6 is a layer to be formed according to need, and the pressure-sensitive adhesive sheet need not always have this layer.

A rubbery organic elastic layer can be formed also as a layer other than the interlayers to be disposed between the substrate and a heat-expandable layer. However, in order for the elastic layer to effectively perform its functions, it is preferably superposed on a heat-expandable layer on the side opposite to the non-heat-expandable pressure-sensitive adhesive layer. A rubbery organic elastic layer may be disposed on one side or each side of the substrate.

The rubbery organic elastic layer is preferably made of natural rubber, a synthetic rubber, or a synthetic resin with rubber elasticity each having a Shore D hardness, as measured in accordance with ASTM D-2240, of 50 or lower, preferably 40 or lower, so as to perform its functions.

Examples of the synthetic rubber or synthetic resin having rubber elasticity include synthetic rubbers such as nitrile rubbers; diene-based rubbers, and acrylic rubbers; thermoplastic elastomers such as polyolefins and polyesters; and synthetic resins having rubber elasticity such as ethylene/yinyl acetate copolymers, polyurethanes, polybutadiene; and flexible poly(vinyl chloride). It should be noted that even polymers which are intrinsically rigid, like poly(vinyl chloride), can have rubber elasticity when used in combination with a compounding agent such as a plasticizer or softener. Such compositions also can be used as constituent materials for the rubbery organic elastic layer. Furthermore, pressure-sensitive adhesive materials such as the pressure-sensitive adhesive constituting a heat-expandable layer can also be advantageously used as constituent materials for the rubbery organic elastic layer.

The rubbery organic elastic layer can be formed, for example, by a method in which a coating fluid containing an elastic layer-forming material, such as natural rubber or any of the aforementioned synthetic rubbers and synthetic resins having rubber elasticity, is applied to the substrate (coating method), a method in which a film made of the elastic layer-forming material or a laminated film produced beforehand by forming a layer of the elastic layer-forming material on one or more heat-expandable layers is bonded to the substrate (dry laminating method); or a method in which a resin composition containing a constituent material for the substrate is coextruded with a resin composition containing the elastic-layer-forming material (coextrusion method).

The thickness of the rubbery organic elastic layer is generally about 500 $\mu$m or smaller (e.g., from 1 to 500 $\mu$m), preferably from about 3 to 300 $\mu$m, more preferably from about 5 to 150 $\mu$m.

The rubbery organic elastic layer may be made of a pressure-sensitive adhesive material comprising natural rubber, a synthetic rubber, or a synthetic resin having rubber elasticity as the main component. Alternatively, the elastic, layer may consist of a foamed film or the like constituted mainly of such rubbery ingredient. Foaming can be conducted by an ordinary technique such as foaming by mechanical stirring, foaming with a gas yielded by a reaction, foaming by a foaming agent, removal of a soluble substance, spraying, formation of a syntactic foam, or sintering. The rubbery organic elastic layer may consist of a single layer or may be composed of two or more layers.

When a radiation-curing substance is used in the heat-expandable layer or non-heat-expandable pressure-sensitive adhesive layer, the rubbery organic elastic layer preferably is one which does not inhibit the radiation from passing therethrough.

Pressure-Sensitive Adhesive Layer:

The pressure-sensitive adhesive sheet of the invention may have a pressure-sensitive adhesive layer 7 as shown in Fig. 3. Namely, the pressure-sensitive adhesive layer 7 can optionally be formed, and the pressure-sensitive adhesive sheet need not always have this layer. This pressure-sensitive adhesive sheet having a pressure-sensitive adhesive layer 7 is advantageous in that an electronic part adherent to the non-heat-expandable pressure-sensitive adhesive layer 42 can be bonded to another adherend (any adherend) by means of the pressure-sensitive adhesive layer 7. The pressure-sensitive adhesive used for forming the pressure-sensitive adhesive layer 7 is not particularly limited, and can use pressure-sensitive adhesives which are known or in common use, such as the pressure-sensitive adhesives enumerated hereinabove as examples of the pressure-sensitive adhesive for the non-heat-expandable pressure-sensitive adhesive layer (e.g., rubber-based pressure-sensitive adhesives, acrylic pressure-sensitive adhesives, vinyl alkyl ether-based pressure-sensitive adhesives, silicone-based pressure-sensitive adhesives, polyester-based pressure-sensitive adhesives, polyamide-based pressure-sensitive adhesives, urethane-based pressure-sensitive adhesives, fluoropolymer-based pressure-sensitive adhesives, styrene/diene block copolymer-based pressure-sensitive adhesives, pressure-sensitive adhesives having improved creep characteristics, and radiation-curing pressure-sensitive adhesives). This pressure-sensitive adhesive layer need not be less contaminative because it is not applied to electronic parts. The pressure-sensitive adhesive used for forming the pressure-sensitive adhesive layer 7 may contain known or ordinary additives such as a plasticizer, filler, surfactant, antioxidant, and tackifier.

The thickness of the pressure-sensitive adhesive layer 7 may be, for example, 300 μm or smaller (e.g., from 1 to 300 μm, preferably from 5 to 100 μm). The pressure-sensitive adhesive layer 7 can be formed by the same methods as for the non-heat-expandable pressure-sensitive adhesive layer.

Liner:

The liner (5, 51, or 52), that can be used in the invention is an ordinary release paper or the like. The liner is used as a protective material for a non-heat-expandable pressure-sensitive adhesive layer, and is peeled off when the pressure-sensitive adhesive sheet is applied to an electronic part. The pressure-sensitive adhesive sheet need not always have a liner.

Examples of the liner include substrates having a release layer, such as plastic films and papers which have been surface-treated with a release agent such as a silicone, long-chain alkyl, or fluorochemical release agent or molybdenum sulfide; poorly bondable substrates made of a fluoropolymer such as polytetrafluoroethylene, polychlorotrifluoroethylene, poly(vinyl fluoride), poly(vinylidene fluoride), a tetrafluoroethylene/hexafluoropropylene copolymer, or a chlorofluoroethylene/vinylidene fluoride copolymer; and poorly bondable substrates made of a nonpolar polymer such as an olefin resin (e.g., polyethylene or polypropylene). The liner can be used as a substrate for supporting the heat-expandable layer.

The liner can be formed by a known or ordinary method. The liner is not particularly limited in thickness, etc.

The heat-peelable pressure-sensitive adhesive sheet for electronic parts of the invention may have a constitution comprising a heat-expandable layer and a non-heat-expandable pressure-sensitive adhesive layer disposed on one or each side of the heat-expandable layer, or may have a constitution comprising a heat-expandable layer and a non-heat-expandable pressure-sensitive adhesive layer which have been formed in this order on one side of a substrate and further comprising at least an ordinary pressure-sensitive adhesive layer containing no heat-expandable microspheres (e.g., the non-heat-expandable pressure-sensitive adhesive layer 41b or pressure-sensitive adhesive layer 7) formed on the other side of the substrate. Furthermore, the heat-peelable pressure-sensitive adhesive sheet having a substrate as a support can be produced as a separable type in which the substrate can be easily peeled from the rubbery organic elastic layer or heat-expandable layer or as a fixed type in which the substrate is tenaciously bonded to the rubbery organic elastic layer or heat-expandable layer. The heat-peelable pressure-sensitive adhesive sheet of the separable type can be produced with, e.g., a liner or a poorly bondable substrate, while the heat-peelable pressure-sensitive adhesive sheet of the fixed type can be produced with, e.g., a strongly bondable substrate or a substrate which has undergone a surface oxidation treatment or the like. It is preferred that the pressure-sensitive adhesive layers such as the non-heat-expandable pressure-sensitive adhesive layer 4 and pressure-sensitive adhesive layer 7 (e.g., an outermost non-heat-expandable pressure-sensitive adhesive layer and an outermost pressure-sensitive adhesive layer) be protected with a liner provisionally adherent thereto so as to prevent them, until practical use, from suffering a decrease in adhesive force, etc. caused by contamination.

The heat-peelable pressure-sensitive adhesive sheet for electronic parts of the invention can be in the form of a sheet, tape, or the like. When applied to an electronic part, the heat-peelable pressure-sensitive adhesive sheet for electronic parts can be bonded at a predetermined adhesive force due to the pressure-sensitive adhesive of the non-heat-expandable pressure-sensitive adhesive layer. When the adhered state is desired to be ended, the sheet can be made easily peelable or separable by a heat treatment due to the heat-expandable microspheres contained in the heat-expandable layer.

In the case of the heat-peelable pressure-sensitive adhesive sheet having a rubbery organic elastic layer interposed between the substrate and the heat-expandable layer; the following effects are brought about. When this pressure-sensitive adhesive sheet is applied to an electronic part, the surface of the pressure-sensitive adhesive sheet satisfactorily conforms to the surface shape of the electronic part due to the elasticity of the rubbery organic elastic layer. As a result, a large adhesion area and an elevated adhesive strength are obtained. When this pressure-sensitive adhesive sheet is heated for peeling, the expansion (volume change) of the heat-expandable layer, can be precisely controlled and this layer can be evenly expanded preferentially in the thickness direction. As a result, the sheet can be peeled off more easily. In addition, even when the heat-expandable microspheres contained in the heat-expandable layer have a somewhat large particle diameter, the uneven surface attributable thereto is buffered by the rubbery organic elastic layer. Consequently, the heat-expandable layer can be regulated so as to have reduced surface roughness.

The heat-peelable pressure-sensitive adhesive sheet for electronic parts of the invention has the advantages described above. For example, pressure-sensitive adhesive properties such as adhesive force can be suitably regulated according to the intended use due to the non-heat-expandable pressure-sensitive adhesive layer; the pressure-sensitive adhesive sheet can be easily peeled off through a heat treatment; and the heat treatment for lowering adhesive force does not result in a considerable increase in the amount of contaminants, in particular, fine contaminants. The heat-peelable pressure-sensitive adhesive sheet can be used for permanently remaining electronic parts bonded. However, due to those advantages, the heat-peelable pressure-sensitive adhesive sheet of the invention is suitable for use in applications in which not only an electronic part remains bonded in a given period and this adhered state is desired to be ended after accomplishment of the purpose of bonding, but also that surface of the electronic part from which the adhesive sheet has been peeled is desired to be less contaminated. In particular, the heat-peelable pressure-sensitive adhesive sheet for electronic parts is most suitable for use as a temporarily fixing material (e.g.; a tape for temporary fixing) in the processing of electronic parts or as a protective material in steps other than processing.

The method for processing an electronic part according to the invention comprises applying the heat-peelable pressure-sensitive adhesive sheet for electronic parts to the electronic part so that the non-heat-expandable pressure-sensitive adhesive layer comes into contact with the electronic part and then processing the electronic part. Examples of the processing of an electronic part include various processings such as the back-side grinding, dicing, and fine processings of semiconductor wafers. During such processings, the heat-peelable pressure-sensitive adhesive sheet for electronic parts functions also to protect the electronic part.

The electronic part is not particularly limited as long as it is known or in common use. Examples thereof include semiconductor wafers (e.g., silicon wafers), multilayered substrates, laminated ceramics, and molding packages. In the invention, a semiconductor wafer or laminated ceramic can be advantageously used as the electronic part. The surface (adhesion side) of the electronic part may have any shape, e.g., a flat or curved shape.

The heat treatment for peeling the heat-peelable pressure-sensitive adhesive sheet from the electronic part can be performed with an appropriate heating unit such as, e.g., a hot plate, hot-air drying oven, or near-infrared lamp. The heating temperature is not particularly limited as long as it is not lower than the temperature at which the heat-expandable microspheres in the heat-expandable layer begin to expand. Conditions for the heat treatment can be suitably determined according to the desired degree of decrease in adhesion area, which depends on the surface state of the electronic part, kind of the heat-expandable microspheres, etc., and to the heat resistance of the substrate and electronic part, method of heating (e.g., heat capacity, heating unit, etc.), and other factors. General conditions for the heat treatment include a temperature of from 100 to 250°C and a heating period of from 5 to 90 seconds (in the case of heating with a hot plate or the like) or from 5 to 15 minutes (in the case of heating in a hot-air drying oven or the like). The heat-expandable pressure-sensitive adhesive layer is heated usually under such conditions to expand and/or foam the heat-expandable microspheres contained therein. As a result, the pressure-sensitive adhesive layer expands and deforms to form uneven surface, and the non-heat-expandable pressure-sensitive adhesive layer also deforms to form uneven surface accordingly, whereby the adhesive force is reduced or lost. The heat treatment can be conducted at a suitable stage according to the intended use. In some cases, an infrared lamp or hot water can be used as a heat source.

Consequently, the electronic part obtained through processing by the processing method of the invention has suffered low surface contamination. From this standpoint, this electronic part is not a defective and can be put to practical use.

The heat-peelable pressure-sensitive adhesive sheet of the invention, after a heat treatment, can be easily peeled from electronic parts while causing little contamination. Furthermore, the adhesive sheet can have excellent peelability after heating while retaining excellent adhesive properties before heating. Consequently, the heat-peelable pressure-sensitive adhesive sheet is useful, e.g., as a temporarily fixing material in the processing of electronic parts.

The invention will be described below in greater detail by reference to Examples, but the invention should not be construed as being limited by these Examples.

**EXAMPLE 1**

50 parts by weight of n-butyl acrylate, 50 parts by weight of 2-ethylhexyl acrylate, 5 parts by weight of acrylic acid, 0.1 part by weight of 2,2'-azobisisobutyronitrile, and 200 parts by weight of ethyl acetate were introduced into a 500 ml three-necked flask reactor equipped with a thermometer, stirrer, nitrogen introduction tube, and reflux condenser so as to result in a total amount of 200 g. The resulting mixture was stirred for about 1 hour while introducing nitrogen gas thereinto to thereby replace the air in the reactor with nitrogen. Thereafter, the temperature inside the reactor was regulated to 58°C and the reaction mixture was maintained in this state for about 4 hours to conduct polymerization. Thus, an acrylic copolymer (often referred to as "acrylic copolymer A") was obtained.

An acrylic pressure-sensitive adhesive prepared by incorporating 2 parts by weight of an isocyanate crosslinking agent into an ethyl acetate solution containing 100 parts by weight of the acrylic copolymer A was mixed with 35 parts by weight of heat-expandable microspheres (trade name "MATSUMOTO MICROSPHERE F-50D", manufactured by Matsumoto Yushi Seiyaku K.K.). This mixture was applied to one side of a 50 $\mu$m-thick poly(ethylene terephthalate) film (PET film) in a thickness of 40 $\mu$m on a dry basis. The coating was dried to form a heat-expandable layer. A non-heat-expandable pressure-sensitive adhesive layer A (contamination-preventive pressure-sensitive adhesive layer) (thickness, 3 $\mu$m) formed by the method shown below was transferred to this heat-expandable layer. Thus, a heat-peelable pressure-sensitive adhesive sheet of the constitution shown in Fig. 1 was obtained.

Non-Heat-Expandable Pressure-Sensitive Adhesive Layer A:

50 parts by weight of n-butyl acrylate, 50 parts by weight of ethyl acrylate, 5 parts by weight of acrylic acid, 0.1 part by weight of 2,2'-azobisisobutyronitrile, and 200 parts by weight of ethyl acetate were introduced into a 500 ml three-necked flask reactor equipped with a thermometer, stirrer, nitrogen introduction tube, and reflux condenser so as to result in a total amount of 200 g. The resulting mixture was stirred for about 1 hour while introducing nitrogen gas thereinto to thereby replace the air in the reactor with nitrogen. The temperature inside the reactor was regulated to 57°C and the reaction mixture was maintained in this state for about 5 hours to conduct polymerization. Thus, an acrylic copolymer (often referred to as "acrylic copolymer B") was obtained. An acrylic pressure-sensitive adhesive prepared by incorporating 3 parts by weight of an epoxy crosslinking agent into an ethyl acetate solution containing 100 parts by weight of the acrylic copolymer B was applied to a liner in a thickness of 3 $\mu$m on a dry basis and then dried. Thus, a non-heat-expandable pressure-sensitive adhesive layer (often referred to as "non-heat-expandable pressure-sensitive adhesive layer A") was formed on the liner.

**EXAMPLE 2**

The same heat-expandable layer (thickness, 40 $\mu$m) as in Example 1 was formed on one side of a 50 $\mu$m-thick PET film in the same manner as in Example 1. A non-heat-expandable pressure-sensitive adhesive layer B (contamination-preventive, radiation-curing, pressure-sensitive adhesive layer) (thickness, 2 $\mu$m) formed by the method shown below was transferred to this heat-expandable layer. Thus, a heat-peelable pressure-sensitive adhesive sheet of the constitution shown in Fig. 1 was obtained.

Non-Heat-Expandable Pressure-Sensitive Adhesive Layer B:

An acrylic pressure-sensitive adhesive prepared by incorporating 100 parts by weight of a urethane acrylate, 3 parts by weight of an isocyanate crosslinking agent, and 3 parts by weight of a radiation polymerization initiator (photopolymerization initiator) into 100 parts by weight of the acrylic copolymer B was applied to a liner in a thickness of 2 $\mu$m on a dry basis and then dried. Thus, a non-heat-expandable pressure-sensitive adhesive layer (often referred to as "non-heat-expandable pressure-sensitive adhesive layer B") was formed on the liner.

## EXAMPLE 3

The same heat-expandable layer (thickness, 40 $\mu$m) as in Example 1 was formed on one side of a 50 $\mu$m-thick PET film in the same manner as in Example 1. A mixture comprising 100 parts by weight of an acrylic copolymer C prepared by the method shown below and 3 parts by weight of an isocyanate crosslinking agent was applied to the heat-expandable layer in a thickness of 3 $\mu$m on a dry basis and then dried. Thus, a non-heat-expandable pressure-sensitive adhesive layer (often referred to as "non-heat-expandable pressure-sensitive adhesive layer C") was formed. Furthermore, a PET film (thickness, 50 $\mu$m) which had been treated with a release agent was superposed on the non-heat-expandable pressure-sensitive adhesive layer so that the treated side of the film faced the adhesive layer. Thus, a heat-peelable pressure-sensitive adhesive sheet of the constitution shown in Fig. 1 was obtained.

Acrylic Copolymer C:

80 parts by weight of 2-ethylhexyl acrylate, 20 parts by weight of acryloylmorpholine, 3 parts by weight of acrylic acid, 0.1 part by weight of 2,2'-azobisisobutyronitrile, and 200 parts by weight of ethyl acetate were introduced into a 500 ml three-necked flask reactor equipped with a thermometer, stirrer, nitrogen introducing tube, and reflux condenser so as to result in a total amount of 200 g. The resultant mixture was stirred for about 1 hour while introducing nitrogen gas thereinto to thereby replace the air in the reactor with nitrogen. The temperature inside the reactor was regulated to 58°C and this mixture was maintained in this state for about 7 hours to conduct polymerization. The resulting reaction mixture (containing a copolymer) was poured into 1 liter of heptane and this mixture was stirred. The solvent phase (heptane phase) was removed, leaving the precipitate. Thus, low molecular components were removed. The same step for removing low molecular components was further conducted twice. Thereafter, ethyl acetate was introduced to adjust the total amount to 200 g. Thus, an ethyl acetate solution containing an acrylic copolymer (often referred to as "acrylic copolymer C") was obtained

## EXAMPLE 4

The same heat-expandable layer (thickness, 40 $\mu$m) as in Example 1 was formed on one side of a 50 $\mu$m-thick PET film in the same manner as in Example 1. A non-heat-expandable pressure-sensitive adhesive layer D (contamination-preventive, radiation-curing, pressure-sensitive adhesive layer) (thickness, 5 $\mu$m) formed by the method shown below was transferred to this heat-expandable layer. Thus, a heat-peelable pressure-sensitive adhesive sheet of the constitution shown in Fig. 1 was obtained.

Non-Heat-Expandable Pressure-Sensitive Adhesive Layer D.

100 parts by weight of butyl acrylate, 2 parts by weight of 2-hydroxyethyl acrylate together, 0.1 part by weight of 2,2'-azobisisobutyronitrile, and 200 parts by weight of ethyl acetate were introduced into a 500 ml three-necked flask reactor equipped with a thermometer, stirrer, nitrogen introduction tube, and reflux condenser so as to result in a total amount of 200 g. The resulting mixture was stirred for about 1 hour while introducing nitrogen gas thereinto to thereby replace the air in the reactor with nitrogen. Thereafter, the temperature inside the reactor was regulated to 58°C and the reaction mixture was kept in this state for about 7 hours to conduct polymerization. Thus, an ethyl acetate solution containing an acrylic copolymer (often referred to as "acrylic copolymer D-1") was obtained 1 part by weight of methacryloyloxyethylene isocyanate and 0.1 part by weight of dibutyltin dilaurate were incorporated into 100 parts by weight of the acrylic copolymer D1, and the resulting mixture was stirred at 50°C for 24 hours while substituting nitrogen gas with air to obtain an ethyl acetate solution containing an acrylic copolymer (often referred to as "acrylic copolymer D"). An acrylic pressure-sensitive adhesive prepared by incorporating 3 parts by weight of an isocyanate crosslinking agent, and 3 parts by weight of a radiation polymerization initiator (photopolymerization initiator) into an ethyl acetate solution containing 100 parts by weight of the acrylic copolymer D was applied to a liner in a thickness of 5 $\mu$m on a dry basis and then dried. Thus, a non-heat-expandable pressure-sensitive adhesive layer (often referred to as "non-heat-expandable pressure-sensitive adhesive layer D") was formed on the liner.

## COMPARATIVE EXAMPLE 1

A heat-peelable pressure-sensitive adhesive sheet as obtained in the same manner as in Example 1, except that a pressure-sensitive adhesive layer was not formed on the heat-expandable layer.

**COMPARATIVE EXAMPLE 2**

70 parts by weight of n-butyl acrylate, 30 parts by weight of ethyl acrylate; 5 parts by weight of acrylic acid, 0.1 part by weight of 2,2'-azobisisobutyronitrile, and 200 parts by weight of toluene were introduced into a 500 ml three-necked flask reactor equipped with a thermometer, stirrer, nitrogen introduction tube, and reflux condenser so as to result in a total amount of 200 g. The resulting mixture was stirred for about 1 hour while introducing nitrogen gas thereinto to thereby replace the air in the reactor with nitrogen. The temperature inside the reactor was regulated to 60°C and the reaction mixture was maintained in this state for about 6 hours to conduct polymerization. Thus, an acrylic copolymer (often referred to as "acrylic copolymer E") was obtained. Two parts by weight of an isocyanate crosslinking agent and 35 parts by weight of heat-expandable microspheres (trade name "MATSUMOTO MICROSPHERE F-50D", manufactured by Matsumoto Yushi Seiyaku K.K.) were incorporated into a toluene solution containing 100 parts by weight of the acrylic copolymer E. This mixture was applied to one side of a 50 $\mu$m-thick PET film in a thickness of 40 $\mu$m on a dry basis. The coating was dried to form a heat-expandable layer having a thickness of 40 $\mu$m. Thus, a heat-peelable pressure-sensitive adhesive sheet was obtained.

**COMPARATIVE EXAMPLE 3**

A pressure-sensitive adhesive sheet was obtained in the same manner as in Example 1, except that a mere pressure-sensitive adhesive layer was formed from the acrylic pressure-sensitive adhesive A without incorporating heat-expandable microspheres thereinto and that no pressure-sensitive adhesive layer was formed thereon.

Evaluation of Adhesiveness:

Each of the pressure-sensitive adhesive sheets having a width of 20 mm obtained in the Examples and Comparative Examples was adhered to a polyester film having a thickness of 25 $\mu$m (trade name "LUMILAR S-10", manufactured by Toray Industries, Inc.). These samples were examined for 180° peel adhesive force (peeling rate, 300 mm/min; 23°C) in-application to a stainless-steel plate (SUS 304BA plate) by the following measuring method (Method of Measuring Adhesive Force to SUS 304BA).

With respect to Examples 1 and 3 and Comparative Examples 1, 2, and 3, the times of the measurement were: before heating; and after 3-minute heating in a 130°C hot-air drying oven. With respect Examples 2 and 4, the times of the measurement were: before irradiation and before heating; after 10-second irradiation with an air-cooling high-pressure mercury lamp (46 mJ/min) (the same applies hereinafter) and before heating; before irradiation and after 3-minute heating in a 100°C hot-air drying oven (the same applies hereinafter); and after the irradiation and after the heating. The results of the evaluation are shown in the column "Adhesive force (N/20 mm)" in the Table below.

Method of Measuring Adhesive Force to SUS 304BA

180° Peel adhesive force (pressure-sensitive adhesive force) (N/20 mm) in application to an SUS 304BA plate was measured in the following manner. Each pressure-sensitive adhesive sheet (20, mm wide) was applied, on the non-heat-expandable pressure-sensitive adhesive layer side or heat-expandable pressure-sensitive adhesive layer side (or on the pressure-sensitive adhesive layer side), to an SUS 304BA plate (which had undergone ultrasonic cleaning in toluene) by pressing the adhesive sheet against the SUS plate by rolling a 2 kg roller forward and backward once on the sheet. The resulting sample was examined for 180° peel adhesive force (pressure-sensitive adhesive force) (N/20 mm) before and after heating (the pressure-sensitive adhesive sheet was peeled off at a rate of 300 mm/min at a temperature of 23$\pm$2°C and a humidity of 65$\pm$5% RH).

Evaluation of Contaminative Property:

Each of the pressure-sensitive adhesive sheets (heat-peelable type) obtained in the Examples and Comparative Examples was adhered to a mirror-polished 4-inch silicon wafer. After these samples were allowed to stand for 1 hour, the adhesive sheets were peeled off at various times according to the adhesive force measuring test described above. The silicon wafer surfaces thus exposed by the peeling were examined by XPS (X-ray photoelectron spectroscopy) using an X-ray photoelectron spectrometer to determine the surface carbon element proportion $R_{C1}$ (%) and simultaneously determine the surface silicon element proportion $R_{Si}$ (%). Furthermore, the original mirror-polished surface of a 4-inch silicon wafer (the mirror-polished surface of a 4-inch silicon wafer to which a pressure-sensitive adhesive sheet had not been applied) was examined by XPS using the X-ray photoelectron spectrometer to determine the surface carbon element proportion $R_{C2}$ (%).

With respect to Examples 1 and 3 and Comparative Examples 1, 2, and 3, the analysis was conducted on a silicon wafer surface from which the adhesive sheet had been peeled without heating and on a silicon wafer surface from which the adhesive sheet had been peeled after 3-minute heating in a 130°C hot-air drying oven. With respect to Examples 2 and 4, the analysis was conducted on a silicon wafer surface from which the adhesive sheet had been peeled without irradiation and heating, and on a silicon wafer surface from which the adhesive sheet had been peeled after 10-second irradiation with an air-cooling high-pressure mercury lamp (46 mJ/min) and 3-minute heating in a 100°C hot-air drying oven.

From the values of $R_{C1}$, $R_{Si}$, and $R_{C2}$ thus obtained, the difference between $R_{C1}$ and $R_{C2}$ [$R_{C1}$-$R_{C2}$, (=$\Delta R_{C1-2}$)] and the ratio of $R_{C1}$ to $R_{Si}$ (%) [$R_{C1}/R_{Si}$ (=$R_{C/Si}$)] were determined to evaluate contaminative properties. The results of the evaluation are shown in Table 1 in the columns "$\Delta R_{C1-2}$" and "$R_{C/Si}$" under "Contaminative property". The larger the value of $\Delta R_{C1-2}$ or $R_{C/Si}$, the higher the degree of contamination. The larger the value of $\Delta R_{C1-2}$ or $R_{C/Si}$ for a sample after heating as compared with that for the sample before heating, the more the heat treatment enhanced contamination.

The X-ray photoelectron spectrometer used was Model "5400", manufactured by ULVAC-PHI, Inc. The analysis was conducted under the conditions of an X-ray source of $MgK_{\alpha}$ 15 kV (300 W), a stage tilt of 45°; and an examination area of 1x3.5 mm.

Determination of Molecular Weight:

Each of the pressure-sensitive adhesive sheets (heat-peelable type) obtained in the Examples 1 and 3 and Comparative Examples 1 to 3 was heat-treated in a 130°C hot-air drying oven for 3 minutes. Thereafter, the surface of the pressure-sensitive adhesive layer was rinsed with tetrahydrofuran (THF), and the resultant THF solution was examined with a gel permeation chromatograph (GPC apparatus) to determine the molecular weight (weight-average molecular weight; Mw).

Furthermore, the pressure-sensitive adhesive sheets (radiation-curing heat-peelable type) obtained in Examples 2 and 4 were irradiated with an air-cooling high-pressure mercury lamp (46 mJ/min) for 10 seconds and then heat-treated in a 130°C hot-air drying oven for 3 minutes. Thereafter, the surface of the pressure-sensitive adhesive layer in each adhesive sheet was rinsed with THF and the determination of molecular weight (weight average molecular weight; Mw) with the GPC apparatus was conducted in the same manner as shown above.

The content (%) of components having a weight average molecular weight (Mw) of 100,000 or lower was determined. The results obtained are shown in the column "Content of components with Mw of 100,000 or lower" in the Table below.

The apparatus used for the analysis was "HLC-8120 GPC" (trade name), manufactured by TOHO Co., and the column used was "TSK gel Super HM-H/H4000/H3000/H2000" (trade name), manufactured by Tosoh Corp.

TABLE

| | | Adhesive force (N/20mm) | | Contaminative property | | | | Content of components with Mw of 100,000 or lower (%) |
| | | | | $\Delta R_{C1-2}$ | | $R_{C/Si}$ | | |
| | | Before heating | After heating | Before heating | After heating | Before heating | After heating | |
| Example 1 | | 2.94 | 0.02 | 15.0 | 25.0 | 0.68 | 2.22 | 10 |
| Example 2 | Before UV irradiation | 1.47 | 0.88 | 13.0 | | 1.10 | | 5 |
| | After UV irradiation | 0.29 | 0 | | 12.0 | | 1.50 | |
| Example 3 | | 4.41 | 0 | 4.2 | 19.0 | 0.34 | 1.10 | 2 |
| Example 4 | Before UV irradiation | 5.88 | 0.49 | 10.2 | | 0.91 | | 0.5 |
| | After UV irradiation | 0.78 | 0 | | 1.2 | | 0.29 | |
| Comparative Example 1 | | 3.43 | 0 | 11.8 | 90.0 | 2.50 | 5.20 | 25 |
| Comparative Example 2 | | 2.74 | 0 | 14.0 | 72.0 | 1.60 | 4.80 | 23 |

Table continued

| | Adhesive force (N/20mm) | | Contaminative property | | | | Content of components with Mw of 100,000 or lower (%) |
|---|---|---|---|---|---|---|---|
| | | | $\Delta R_{C1-2}$ | | $R_{C/Si}$ | | |
| | Before heating | After heating | Before heating | After heating | Before heating | After heating | |
| Comparative Example 3 | 3.04 | 4.12 | 30.0 | 55.0 | 0.56 | 3.00 | 20 |

The Table shows the following. The pressure-sensitive adhesive sheet obtained in Example 1 had undergone a considerable decrease in adhesive force through the heat treatment. The pressure-sensitive adhesive sheets of Examples 2 and 4 were able to be deprived almost completely of the adhesive force by the ultraviolet irradiation. It was thus ascertained that the pressure-sensitive adhesive sheet obtained in Example 1 can be made easily peelable by mere heating with a hot-air drying oven.

In the pressure-sensitive adhesive sheets obtained in Examples 1 to 4, the values of $\Delta R_{C1-2}$ and $R_{C/Si}$ for the silicon wafer surfaces from which the adhesive sheets had been peeled after heating were not significantly larger than the values of $\Delta R_{C1-2}$ and $R_{C/Si}$ for the silicon wafer surfaces from which the adhesive sheets had been peeled without heating. In particular, in the pressure-sensitive adhesive sheets of Examples 2 and 4, the former values were smaller than the latter. In contrast, in the case of the pressure-sensitive adhesive sheets obtained in Comparative Examples 1 to 3, the values of $\Delta R_{C1-2}$ and $R_{C/Si}$ for the silicon wafer surfaces from which the adhesive sheets had been peeled after heating were considerably larger than the values of $\Delta R_{C1-2}$ and $R_{C/Si}$ for the silicon wafer surfaces from which the adhesive sheets had been peeled without heating. From the results of determination of the content of components having a weight average molecular weight of 100,000 or lower, it is thought that the higher the content of low molecular polymer components having a weight average molecular weight of 100,000 or lower in the pressure-sensitive adhesive layer in contact with a silicon wafer surface, the higher the degree of contamination of the wafer surface after heating.

## Claims

1. A heat-peelable pressure-sensitive adhesive sheet for electronic parts which comprises a heat-expandable layer containing heat-expandable microspheres and a non-heat-expandable pressure-sensitive adhesive layer formed on at least one side of the heat-expandable layer, wherein the non-heat-expandable pressure-sensitive adhesive layer comprises a pressure-sensitive adhesive in which the content of low-molecular polymer components having a weight-average molecular weight of 100,000 or lower is 15% by weight or lower based on all polymer components.

2. The heat-peelable pressure-sensitive adhesive sheet for electronic parts as claimed in claim 1, wherein the heat-expandable layer is a heat-expandable pressure-sensitive adhesive layer having both thermal expansibility and pressure-sensitive adhesive properties and has been formed on at least one side of a substrate.

3. The heat-peelable pressure-sensitive adhesive sheet for electronic parts as claimed in claim 1 or 2, wherein the non-heat-expandable pressure-sensitive adhesive layer comprises a pressure-sensitive adhesive, which is a less contaminative radiation-curing pressure-sensitive adhesive.

4. The heat-peelable pressure-sensitive adhesive sheet for electronic parts as claimed in claim 3, wherein the less contaminative radiation-curing pressure-sensitive adhesive cures so that the content of low molecular polymer components having a weight average molecular weight of 100,000 or lower in the cured adhesive is 15% by weight or lower based on all polymer components.

5. The heat-peelable pressure-sensitive adhesive sheet for electronic parts as claimed in claim 1 or 2, which comprises the heat-expandable layer and non-heat-expandable pressure-sensitive adhesive layer formed in this order on one side of a substrate and further comprises at least a pressure-sensitive adhesive layer formed on the other side of the substrate.

6. A method of processing an electronic part which comprises: applying the heat-peelable pressure-sensitive adhesive sheet as claimed in claim 1 to the electronic part so that the non-heat-expandable pressure-sensitive adhesive layer comes into contact with the electronic part; and then processing the electronic part.

7. An electronic part produced through a processing conducted by the method of processing as claimed in claim 6.

**Patentansprüche**

1. Durch Wärme ablösbare druckempfindliche Klebefolie für elektronische Teile, welche umfasst eine durch Wärme expandierbare Schicht, die durch Wärme expandierbare Mikrokugeln enthält, und eine nicht durch Wärme expandierbare druckempfindliche Klebstoffschicht, gebildet auf wenigstens einer Seite der durch Wärme expandierbaren Schicht, worin die nicht durch Wärme expandierbare druckempfindliche Klebstoffschicht einen druckempfindlichen Klebstoff umfasst, in welchem der Gehalt von niedermolekularen Polymerkomponenten mit einem Molekulargewicht-Gewichtsmittel von 100000 oder weniger 15 Gew.-% oder weniger, bezogen auf sämtliche Polymerkomponenten, beträgt.

2. Durch Wärme ablösbare druckempfindliche Klebefolie für elektronische Teile wie in Anspruch 1 beansprucht, wohin die durch Wärme expandierbare Schicht eine durch Wärme expandierbare druckempfindliche Klebstoffschicht mit sowohl thermischer Expandierbarkeit als auch druckempfindlichen Klebeeigenschaften ist und auf wenigstens einer Seite eines Substrats gebildet worden ist.

3. Durch Wärme ablösbare druckempfindliche Klebefolie für elektronische Teile wie in Anspruch 1 oder 2 beansprucht, worin die nicht durch Wärme expandierbare druckempfindliche Klebstoffschicht einen druckempfindlichen Klebstoff umfasst, der ein weniger verunreinigender, durch Strahlung härtender druckempfindlicher Klebstoff ist.

4. Durch Wärme ablösbare druckempfindliche Klebefolie für elektronische Teile wie in Anspruch 3 beansprucht, worin der weniger verunreinigende, durch Strahlung härtende druckempfindliche Klebstoff so härtet, dass der Gehalt von niedermolekularen Polymerkomponenten mit einem Molekulargewicht-Gewichtsmittel von 100000 oder weniger in dem gehärteten Klebstoff 15 Gew.-% oder weniger, bezogen auf sämtliche Polymerkomponenten, beträgt.

5. Durch Wärme ablösbare druckempfindliche Klebefolie für elektronische Teile wie in Anspruch 1 oder 2 beansprucht, welche die durch Wärme expandierbare Schicht und die nicht durch Wärme expandierbare druckempfindliche Klebstoffschicht umfasst, gebildet in dieser Reihenfolge auf einer Seite eines Substrats, und weiter wenigstens eine druckempfindliche Klebstoffschicht umfasst, gebildet auf der anderen Seite des Substrats.

6. Verfahren zum Verarbeiten eines elektronischen Teils, welches umfasst: Aufbringen der durch Wärme ablösbaren druckempfindlichen Klebefolie, wie in Anspruch 1 beansprucht, auf das elektronische Teil derart, dass die nicht durch Wärme expandierbare druckempfindliche Klebstoffschicht in Kontakt mit dem elektronischen Teil kommt, und dann Verarbeiten des elektronischen Teils.

7. Elektronisches Teil, hergestellt durch eine Verarbeitung, durchgeführt durch das Verarbeitungsverfahren wie in Anspruch 6 beansprucht.

**Revendications**

1. Feuille adhésive sensible à la pression pelable par la chaleur pour des pièces électroniques qui comprend une couche expansible par la chaleur contenant des microsphères expansibles par la chaleur et une couche adhésive sensible à la pression non expansible par la chaleur formée sur au moins une face de la couche expansible par la chaleur, dans laquelle la couche adhésive sensible à la pression non expansible par la chaleur comprend un adhésif sensible à la pression dans lequel la quantité de composants polymères à bas poids moléculaire ayant une masse moléculaire moyenne en poids de 100 000 ou inférieure est de 15 % en poids ou inférieure rapportée à tous les composants polymères.

2. Feuille adhésive sensible à la pression pelable par la chaleur pour des pièces électroniques selon la revendication 1, dans laquelle la couche expansible par la chaleur est une couche adhésive sensible à la pression expansible par la chaleur ayant à la fois des propriétés d'expansibilité thermique et d'adhésivité sensible à la pression et ayant été formée sur au moins une face d'un substrat.

3. Feuille adhésive sensible à la pression pelable par la chaleur pour des pièces électroniques selon la revendication 1 ou 2, dans laquelle la couche adhésive sensible à la pression non expansible par la chaleur comprend un adhésif sensible à la pression, qui est un adhésif sensible à la pression durcissant par radiation moins contaminant.

4. Feuille adhésive sensible à la pression pelable par la chaleur pour des pièces électroniques selon la revendication 3, dans laquelle l'adhésif sensible à la pression durcissant par radiation moins contaminant durcit de telle manière que la quantité des composants polymères à bas poids moléculaire ayant une masse moléculaire moyenne en poids de 100 000 ou inférieure dans l'adhésif durci est de 15 % en poids ou inférieure rapportée à tous les composants polymères.

5. Feuille adhésive sensible à la pression pelable par la chaleur pour des pièces électroniques selon la revendication 1 ou 2, qui comprend la couche expansible par la chaleur et la couche adhésive sensible à la pression non expansible par la chaleur formées dans cet ordre sur une face d'un substrat et en outre comprend au moins une couche adhésive sensible à la pression formée sur l'autre face du substrat.

6. Procédé de traitement d'une pièce électronique qui comprend les étapes consistant à : appliquer la feuille adhésive sensible à la pression pelable par la chaleur selon la revendication 1 à la pièce électronique de manière que la couche adhésive sensible à la pression non expansible par la chaleur vienne en contact avec la pièce électronique ; et à traiter ensuite la pièce électronique.

7. Pièce électronique produite par un traitement effectué par le procédé de traitement selon la revendication 6.

## FIG. 1

## FIG. 2

FIG. 3